Europäisches Patentamt

(19) European Patent Office

Office européen des brevets

(11) Veröffentlichungsnummer: **0 231 763**
**B1**

(12) **EUROPÄISCHE PATENTSCHRIFT**

(45) Veröffentlichungstag der Patentschrifft:
21.03.90

(21) Anmeldenummer: 87100229.1

(22) Anmeldetag: 09.01.87

(51) Int. Cl.⁵: **G 01 R 31/26, G 01 R 31/02**

(54) **Prüfeinrichtung für parallelgeschaltete FET's.**

(30) Priorität: 17.01.86 DE 3601192

(43) Veröffentlichungstag der Anmeldung:
12.08.87 Patentblatt 87/33

(45) Bekanntmachung des Hinweises auf die Patenterteilung:
21.03.90 Patentblatt 90/12

(84) Bennante Vertragsstaaten:
AT BE CH DE FR GB IT LI SE

(56) Entgegenhaltungen:

RADIO FERNSEHEN ELEKTRONIK, Band 29, Nr. 6, 1980, Seiten 387-389, Berlin, DD; R. PALM et al.: "Tester für analoge Bauelemente"

PATENT ABSTRACTS OF JAPAN, Band 7, Nr. 220 (P-226) 1365 , 30. September 1983; & JP-A-58 111 763

IBM TECHNICAL DISCLOSURE BULLETIN, Band 21, Nr. 7, Dezember 1978, Seiten 2806-2808, New York, US; G.A. MALEY et al.: "Error detecting circuit for open input terminals"

E.D.N. ELECTRICAL DESIGN NEWS, Band 30, Nr. 11, Mai 1985, Seite 234, Boston, Massachussetts, US; T. MOREY: "Test power MOSFETs with a DVM"

(73) Patentinhaber: **AEG - Elotherm GmbH**
**Hammesberger Strasse 31**
**D-5630 Remscheid-Hasten (DE)**

(72) Erfinder: **Busch, Bernd**
**Burger Strasse 284**
**D-5630 Remscheid (DE)**

(74) Vertreter: **Patentanwaltsbüro Cohausz & Florack**
**Schumannstrasse 97**
**D-4000 Düsseldorf 1 (DE)**

## Beschreibung

Die Erfindung bezieht sich auf eine Prüfeinrichtung für parallelgeschaltete FET's, insbesondere MOS-FET's.

Die Ermittlung eines defekten Elementes in einer aus zahlreichen MOS-FET's bestehenden Parallelschaltung ist nach der herkömmlichen ohmschen Meßmethode recht aufwendig. Hinzu kommt, daß nicht alle Fehler mit dieser Meßmethode ermittelt werden können.

Aufgabe der Erfindung ist es, eine Prüfeinrichtung zu schaffen, mit der ein defekter FET auf einfache Art und Weise ermittelt werden kann.

Diese Aufgabe wird erfindungsgemäß dadurch gelöst, daß die FET's mit ihren durch Vorschaltwiderstände voneinander entkoppelten Eingängen an einem Impulsgeber angeschlossen sind und daß der Spannungsabfall an den Vorschaltwiderständen einer an den Vorschaltwiderständen angeschlossenen und durch den Impulsgeber getakteten Auswerteelektronik in vorgegebener Reihenfolge nach dem Takt der Impulse aufschaltbar ist.

Mit einer solchen Prüfeinrichtung läßt sich sowohl im Betriebszustand als auch bei unterbrochenem Betrieb der in einem Gerät eingebauten Parallelschaltung prüfen, ob ein FET und welcher defekt ist. Die Prüfmethode beruht auf dem für jeden Fehler eines solchen FET's typischen Effekt, daß für einen auf den Eingang gegebenen Impuls kein Entladeimpuls folgt. Durch Kontrolle des Spannungsabfalls an den Vorschaltwiderständen der im Takt der Impulse des Impulsgebers nacheinander abgefragten FET's liefert die Auswerteelektronik die gewünschte Aussage, ob und welcher FET defekt ist. Bei Prüfung im Betrieb werden die für den Betrieb der FET's von dem internen Impulsgeber der Schaltung gelieferten Impulse verwendet, die in diesem Fall die Auswerteelektronik takten. Bei unterbrochenem Betrieb wird ein externer Impulsgeber eingesetzt. Sofern der Impulsgeber aus Oszillator und Treiber besteht, kann ein externer Oszillator mit dem schaltungsinternen Treiber verwendet werden.

Im folgenden wird die Erfindung anhand einer eine Prinzipschaltung eines Ausführungsbeispiels darstellenden Zeichnung näher erläutert, wobei rechts neben der Schaltung für die einzelnen FET's die charakteristischen Impulse dargestellt sind.

Ein Impulsgeber 1 liefert über Vorschaltwiderstände $R_{v1}$, $R_{v2}$, $R_{v3}$ an im Ersatzschaltbild dargestellte MOS-FET's $MF_1$, $MF_2$, $MF_3$ Rechteckimpulse, die im Impulsdiagramm rechts oben dargestellt sind. Die Vorschaltwiderstände $R_{v1}$, $R_{v2}$, $R_{v3}$ entkoppeln die Eingänge der MOS-FET's $MF_1$, $MF_2$, $MF_3$ voneinander. Der Impulsgeber 1 arbeitet als Treiber im Push-Pull-Betrieb. Der Impulsgeber 1 kann der in der Schaltung ohnehin vorhandene Impulsgeber sein. Mit diesem Impulsgeber ist allerdings nur im Betrieb eine Prüfung möglich. Bei unterbrochenem Betrieb müssen die Impulse extern erzeugt werden, wobei allerdings bei einem aus Oszillator und Treiber bestehenden Impulsgeber der schaltungsinterne Treiber mit einem externen Oszillator verwendet werden kann.

Der Spannungsabfall an den einzelnen Vorschaltwiderständen $R_{v1}$, $R_{v2}$, $R_{v3}$ wird potentialgetrennt einer Auswerteelektronik 2 mit einer Anzeige 3 zugeführt. Die Auswerteelektronik 2 wird von den Impulsen des Impulsgebers 1 derart getaktet, daß nacheinander die Spannungsabfälle an den Vorschaltwiderständen $R_{v1}$, $R_{v2}$, $R_{v3}$ abgefragt werden können.

In der Schaltung ist der obere MOS-FET $MF_1$ fehlerfrei. Der mittlere MOS-FET $MF_2$ weist einen Defekt auf, der einem Kurzschluß 4 über der Eingangskapazität entspricht. Der untere MOS-FET $MF_3$ weist einen Fehler auf, der einer Unterbrechung 5 am Gate entspricht. Wie die zugehörigen Impulsdiagramme zeigen, ergibt sich für einen fehlerfreien MOS-FET ein typisches Impulsdiagramm mit einem dem Ladestrom und Entladestrom entsprechenden Spannungsabfall am Vorschaltwiderstand $R_{v1}$. Bei einem Fehler, der einem eingangsseitigen Kurzschluß 4 entspricht, ist am Vorschaltwiderstand $R_{v2}$ nur ein dem Eingangsimpuls entsprechender Rechteckimpuls feststellbar, während bei einem Fehler, der einer eingangsseitigen Unterbrechung 5 entspricht, überhaupt kein Impuls auftritt. Durch das im Takt der Impulse des Impulsgebers 1 erfolgende serielle Abfragen der Spannungsabfälle an den einzelnen Vorschaltwiderständen $R_{v1}$, $R_{v2}$, $R_{v3}$ kann die Auswerteelektronik 2 in der Anzeige 3 angeben, welcher MOS-FET einen Fehler aufweist. Diese Abfrage ist im Betrieb mit dem in der Schaltung ohnehin vorhandenen Impulsgeber und/oder bei unterbrochenem Betrieb mit einem zusätzlichen Impulsgeber möglich.

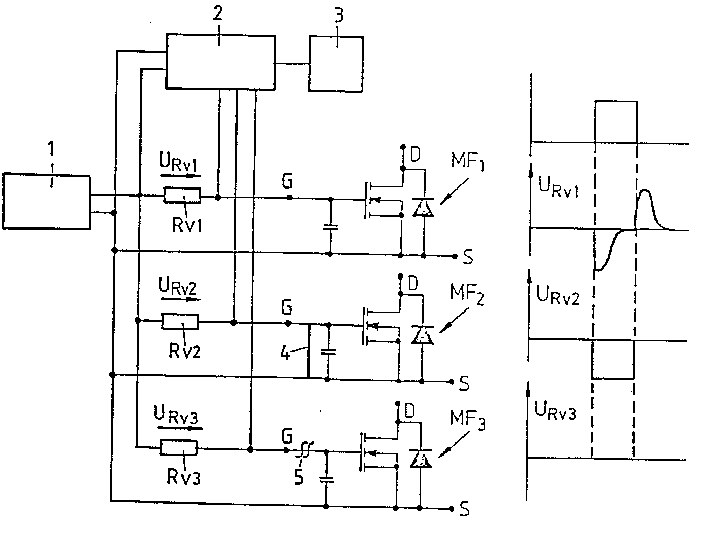

## Patentanspruch

Prüfeinrichtung für parallelgeschaltete FET's, insbesondere MOS-FET's, *dadurch gekennzeichnet*, daß die FET's mit ihren durch Vorschaltwiderstände ($R_{v1}$, $R_{v2}$, $R_{v3}$) voneinander entkoppelten Eingängen an einem Impulsgeber (1) angeschlossen sind und daß der Spannungsabfall an den Vorschaltwiderständen ($R_{v1}$, $R_{v2}$, $R_{v3}$) einer an den Vorschaltwiderständen ($R_{v1}$, $R_{v2}$, $R_{v3}$) angeschlossenen und durch den Impulsgeber (1) getakteten Auswerteelektronik (2) in vorgegebener Reihenfolge nach dem Takt der Impulse aufschaltbar ist.

## Claim

A testing system for parallel-mounted FETs, more particularly MOS-FETs, characterized in that the FETs are connected to a pulse transmitter (1) via their inputs, decoupled from one another by series resistors ($R_{v1}$, $R_{v2}$, $R_{v3}$), and the drop in voltage across the series resistors ($R_{v1}$, $R_{v2}$, $R_{v3}$) can be superimposed on an electronic evaluating system (2), connected to the series resistors ($R_{v1}$,

Rv2, Rv3) and timed by the pulse transmitter (1), in a given sequence in accordance with the timing of the pulses.

## Revendication

Dispositif d'essai pour transistors à effet de champ montés en parallèle, en particulier des transistors à effet de champ à grille isolée par oxyde métallique, caractérisé en ce que les transistors à effet de champ sont raccordés à un impulseur (1) par leurs entrées découplées les unes des autres par des résistances de série ($R_{v1}$, $R_{v2}$, $R_{v3}$) et que la chute de tension aux résistances de série ($R_{v1}$, $R_{v2}$, $R_{v3}$) peut être verrouillée dans une suite prédéterminée selon la fréquence des impulsions à une électronique d'évaluation (2) raccordée aux résistances de série ($R_{v1}$, $R_{v2}$, $R_{v3}$) et synchronisée par l'impulseur (1).